# EUROPÄISCHE PATENTSCHRIFT

(11) **EP 2 250 675 B1**
(45) Veröffentlichungstag und Bekanntmachung des Hinweises auf die Patenterteilung: **27.04.2016**
(21) Anmeldenummer: 09711197.5
(22) Anmeldetag: 11.02.2009
(51) Int. Cl.: H01L 31/0224, H01L 31/18

(54) **VERFAHREN ZUR HERSTELLUNG MONOKRISTALLINER N-SILIZIUM-SOLARZELLEN**
METHOD FOR THE PRODUCTION OF MONOCRYSTALLINE N-SILICON SOLAR CELLS
PROCEDE DE FABRICATION DE CELLULES SOLAIRES MONOCRISTALLINES EN SILICIUM DOPE N

(30) Priorität: 15.02.2008 DE 102008009268; 10.03.2008 DE 102008013446
(43) Veröffentlichungstag der Anmeldung: 17.11.2010
(73) Patentinhaber: SolarWorld Industries Thüringen GmbH, 99310 Arnstadt (DE)
(72) Erfinder: KROKOSZINSKI, Hans-Joachim, 69226 Nußloch (DE); LOSSEN, Jan, 99086 Erfurt (DE)
(74) Vertreter: Isarpatent
(86) Internationale Anmeldenummer: PCT/EP2009/051569
(87) Internationale Veröffentlichungsnummer: WO 2009/101107

(56) Entgegenhaltungen:
- EP-A- 0 776 051
- US-A1- 2005 172 996
- US-B1- 6 262 359
- US-B1- 6 998 288
- LAMMERT, M.D.; SCHWARTZ, R.J.: "The interdigitated back contact solar cell: A silicon solar cell for use in concentrated sunlight" IEEE TRANSACTIONS ON ELECTRON DEVICES, Bd. 24, Nr. 4, April 1977 (1977-04), Seiten 337-342, XP002533731
- SALAMI, J.; CRUZ, B.; SHAIKH, A: "Diffusion Paste Development for Printable IBC and Bifacial Silicon Solar Cells" CONFERENCE RECORD OF THE 2006 IEEE 4TH WORLD CONFERENCE ON PHOTOVOLTAIC ENERGY CONVERSION, Bd. 2, Mai 2006 (2006-05), Seiten 1323-1325, XP002533732
- CUEVAS A ET AL: "Back junction solar cells on n-type multicrystalline and CZ silicon wafers", PROCEEDINGS OF THE 3RD WORLD CONFERENCE ON PHOTOVOLTAIC ENERGY CONVERSION : JOINT CONFERENCE OF 13TH PV SCIENCE & ENGINEERING CONFERENCE, 30TH IEEE PV SPECIALISTS CONFERENCE, 18TH EUROPEAN PV SOLAR ENERGY CONFERENCE; OSAKA INTERNATIONAL CONGRESS CENT, vol. 1, 11 May 2003 (2003-05-11), pages 963-966, XP009142050, DOI: 10.1109/WCPEC.2003.1305443 ISBN: 978-4-9901816-0-4

## Beschreibung

Die Erfindung betrifft ein Verfahren zur Herstellung monokristalliner n-Silizium-Solarzellen mit rückseitigem p⁺-Emitter und rückseitigen, räumlich getrennten, oberflächennah hochdotierten n⁺⁺-Basisbereichen sowie einer interdigitalen Rückseiten-Kontaktfingerstruktur, welche jeweils in leitender Verbindung mit den p⁺-Emitterbereichen und den n⁺⁺-Basisbereichen steht, gemäß Oberbegriff des Patentanspruchs 1 sowie eine Solarzelle, hergestellt nach einem derartigen Verfahren.

Rückseitenkontakt-Solarzellen auf monokristallinen n-Si-Wafern werden seit mehreren Jahren von verschiedenen Solarzellen-Herstellern entwickelt und sind zum Teil bereits auf dem Markt erhältlich.

Verweisen sei hier beispielsweise auf die sogenannte A300-Zelle der Firma SunPower (siehe W.D. Mulligan, D.H. Rose, M.J. Cudzinovic, D.M. DeCeuster, K.R. Mclntosh, D.D. Smith, R.M. Swanson, "Manufacture of solar cells with 21% efficieny", Proceedings of the 19th European Photovoltaic Solar Energy Conference, Paris, Frankreich (2004)). Es handelt sich bei der A300-Zelle um eine sogenannte Interdigitated Back Contact Zelle (IBC), was bedeutet, dass sich sowohl die Emitter- als auch die BSF- (Back Surface Field) bzw. Basiskontaktstreifen auf der Zellenrückseite befinden und wie zwei ineinander greifende Gabelstrukturen ausgebildet sind.

Die erforderliche elektrische Trennung von nebeneinander liegenden n-dotierten und p-dotierten Halbleiterbereichen auf derselben Oberfläche kann auf verschiedene Weise gelöst werden. So besteht die Möglichkeit, die beiden Bereiche auf unterschiedliche Höhe zu legen, indem mittels Laserablation das auf der Rückseitenoberfläche abgeschiedene Siliziumoxid um die als Basiskontakte vorgesehenen Bereiche herum entfernt wird (P. Engelhardt, N.-P. Harder, T. Neubert, H. Plagwitz, B. Fischer, R. Meyer and R. Brendel, "Laser Processing of 22% Efficient Back-Contated Silicon Solar Cells", 21st European Photovoltaic Solar Energy Conference, Dresden, 2006, S. 1).

Nachdem mit nasschemischer Ätzung die durch den Laserprozess hervorgerufene Oberflächenschädigung sowie etwa 20µm des Siliziums abgetragen worden sind, wird mit einem Standard-POCl₃-Prozess die Emitterdotierung mit Phosphor gleichzeitig in die tiefer gelegenen Bereiche der Rückseite, in die Vorderseite und die Verbindungslöcher zwischen Frontemitter und Rückseitenemitter vorgenommen.

Die Metallisierung beider Bereiche erfolgt dann durch einen einzigen Aluminiumaufdampfschritt, wobei die Kontaktbereiche durch Abriss der dünnen Metallschicht an der erzeugten fast senkrechten Stufenstruktur in der Halbleiteroberfläche elektrisch voneinander getrennt werden.

Technologien für die Herstellung von passivierten Emittern und von lokalen, punktuellen Kontakten zu den beiden Halbleitergebieten Basis und Emitter sind ebenfalls bekannt und in der Literatur gewürdigt (siehe R.A. Sinton, Y. Kwark, R.M. Swanson, "Recombination Mechanisms in Silicon Solar Cells", 14th Project Integration Meeting, Photovoltaic Concentrator Technology Project, Juni 1986, S. 117-125).

Die lokale Öffnung der Passivierschicht, die gleichzeitig Isolation zwischen den Halbleitergebieten und den darüber liegenden metallischen Strombahnen ist, wird zunehmend mit dem Laser durchgeführt. Einerseits wird hier die oben genannte Laserablation angewandt, um lediglich die Isolationsschicht lokal zu entfernen. Andererseits wird das sogenannte Laser Fired Contacts-Verfahren (LFC) genutzt, bei dem durch Laserblitze die aufgedampfte oder gesputterte Aluminiumschicht durch die Isolationsschicht hindurch bewegt wird, um darunter liegende Halbleitergebiete zu kontaktieren.

Aus der DE 696 31 815 T2 (auch veröffentlicht als EP 0 776 051 A2) ist es bekannt, als Leiterbasis für die p-Emitterstruktur ein AlSi-Eutektikum zu verwenden, das nach der Diffusion von Aluminium durch eine vorher eindiffundierte n⁺-Schicht der Rückseite hindurch in das Silizium oberflächig entsteht. Die dortige Lösung verwendet weiterhin ein Siebdrucken von Aluminiumpaste durch Oxidfenster hindurch über den n-Basisbereichen. Der Nachteil dieser Lösung ist, dass die Aluminiumdotierung und die Kontaktierung des Aluminiumemitters in einem Schritt, d.h. großflächig ausgeführt werden muss, so dass die Fläche des Emitters und die Fläche der Metallkontaktierung identisch sind. Damit ist keine Passivierung des Emitters mit lokalen Kontakten möglich. Die Folge hiervon ist eine große Oberflächenrekombinationsgeschwindigkeit und damit ein relativ niedriger Wirkungsgrad.

Sowohl die Laserablation als auch das LFC-Verfahren für die Herstellung lokaler Kontakte haben den Nachteil, dass diese Verfahren sequentieller Natur sind. Dies bedeutet, dass für jeden Wafer einzelnen die Löcher nacheinander hergestellt werden müssen.

Aus dem Vorgenannten ist es daher Aufgabe der Erfindung, ein weiterentwickeltes Verfahren zur Herstellung monokristalliner n-Silizium-Solarzellen mit rückseitigem, passivierten p⁺-Emitter und räumlich getrennten, oberflächennah hochdotierten n⁺⁺-Basisbereichen sowie mit einer interdigitalen Rückseiten-Kontaktfingerstruktur anzugeben, welches eine hohe Produktivität ermöglicht und das die Nachteile des Standes der Technik vermeidet.

Darüber hinaus soll die Möglichkeit geschaffen werden, technologische Schritte, insbesondere solche, die im Fertigungsprozess zeitaufwendig sind, zusammenzuführen, um eine weitere Produktivitätsverbesserung zu sichern. Weiterhin gilt es, waferschonende Technologien aus der Mikroelektronikchip-Produktion, wie Sputtern, Aufdampfen, CVD, maskiertes Trockenätzen von Aluminium und von Oxiden mit jeweils verschiedenen Halogenplasmen sowie Ink-Jetten für die Herstellung von Solarzellen zu erschließen.

Die Lösung der Aufgabe der Erfindung erfolgt verfahrensseitig mit der Lehre nach Patentanspruch 1, wobei die Unteransprüche mindestens zweckmäßige Ausgestaltungen und Weiterbildungen darstellen.

Erfindungswesentlich ist die Herstellung eines rückseitigen, lokal diffundierten und passivierten Aluminium-Emitters und die Möglichkeit, eine simultane beidseitige und lokale n⁺-Dotierung von n-Silizium in den rückseitigen und vorderseitigen oberflächennahen n-Basisbereichen vorzunehmen. Es können erfindungsgemäß die Diffusionsschritte für die auszubildenden Emitter und den BSF- bzw. FSF-Bereich in einem gemeinsamen Temperaturbehandlungsschritt für die Diffusion des gewählten Emitterdotiermaterials Aluminium und des gewählten BSF / FSF-Dotanden Phosphor vorgenommen werden.

Der Wafer kann vor dem Aufbringen und dem Strukturieren der aluminiumhaltigen Ausgangsschicht für die Emitterdotierung bereits auf einer Seite texturiert sein. Es ist aber ebenso möglich, die Texturierung des Wafers erst nach Abscheidung des Aluminiums und seiner Beschichtung mit einem ätzresistenten Oxid auf der Rückseite vorzunehmen, so dass der Emitter und damit der größte Teil der Rückseite untexturiert bleibt.

Die Erfindung legt im Übrigen weiterhin dar, wie sich die Prozessfolge bis zur fertigen Rückseitenkontakt-Solarzelle darstellt, und zwar einschließlich der Passivierung von Vorder- und Rückseite sowie der Kontaktstrukturherstellung inklusive chemischer oder galvanischer Verstärkung.

Erfindungswesentlich ist auch die an der fertigen Solarzelle verkörperte laterale Trennung der Emitter- und Basisdotiermaterialien und damit die für Solarzellen neuartige Technik der Zellenherstellung.

Basis des erfindungsgemäßen Verfahrens ist das Abscheiden einer Aluminium- oder aluminiumhaltigen Dünnschicht auf der Rückseite des n-Siliziumwafers sowie die anschließende Strukturierung dieser Dünnschicht mit Erhalt von Öffnungen im Bereich der späteren Basiskontakte. In einem weiteren Prozessschritt erfolgt dann das Eindiffundieren des Aluminiums in den n-Siliziumwafer zur Ausbildung einer strukturierten Emitterschicht. Es wird demnach die Aluminium- oder aluminiumhaltige Schicht strukturiert, bevor sie selbst in den Wafer eindiffundiert wird.

Die erwähnte Aluminium-Dünnschicht kann durch einen Aufdampf- oder Sputterprozess auf dem Wafer abgeschieden werden.

Die Strukturierung der abgeschiedenen Aluminium-Dünnschicht erfolgt streifenförmig bevorzugt durch ein selektives Ätzen. Hier können Trockenätzverfahren über eine Metall-Schattenmaske genutzt werden, wobei auch der Einsatz einer organischen Maske möglich ist. Selbstverständlich kann auch ein nasschemisches Ätzen vorgenommen werden bzw. ein selektives Ätzen mittels lokalem Drucken einer Ätzpaste erfolgen.

Die strukturierte Emitterschicht wird in einem weiteren Verfahrensschritt vollflächig mit einer dielektrischen Schutzschicht bedeckt. Weiterhin wird diese Schutzschicht in Bereichen späterer Basisdotierung geöffnet, was wiederum durch Ätzen bzw. mit Hilfe einer Ätzmaske realisiert werden kann.

Anschließend wird der Siliziumwafer einer Texturierung unterzogen, wobei die Texturierung auf der Wafer-Vorderseite und im Bereich der Öffnungen in der dielektrischen Schutzschicht erfolgt.

Diese Öffnungen können über eine Streifenätzmaske ausgebildet werden, wobei die Breite der erzeugten Öffnungen kleiner ist als die Breite der aluminiumfreien streifenförmigen Bereiche im Wafer.

Im Bereich der Öffnungen in der dielektrischen Schutzschicht erfolgt zur Ausbildung der oberflächennahen hochdotierten n⁺⁺BSF-Basisbereiche eine Belegung mit stark phosphorhaltigem Material.

Diese Belegung kann durch Aufbringen einer Paste mittels Sieb- oder Schablonendruck, durch Ink-Jetting in lokalen Depots oder dergleichen Verfahren vorgenommen werden.

Die aufgebrachte Paste wird, wenn notwendig, einem Trocknungsschritt unterzogen.

Das BSF-Dotiermaterial wird dann in einem ein- oder mehrstufigen Temperaturbehandlungsschritt eindiffundiert.

Das Eindiffundieren des Aluminiums als Emitterdotand und das Eindiffundieren des BSF-Dotiermaterials kann in einem gemeinsamen Behandlungsschritt in besonders prozessökonomischer Weise erfolgen.

Über eine weitere Temperaturbehandlung in einer phosphorhaltigen, insbesondere POCl₃-Atmosphäre kann auf der Wafer-Vorderseite eine flache Phosphor-Diffusionsschicht (FSF - Front Surface Field) mit einem durch Behandlungstemperatur und Behandlungszeit einstellbaren Schichtwiderstand erzeugt werden.

Über ein Ätzbad werden Reste der Dotiermaterialien, gebildetes Phosphor-Silikatglas, Reste der Isolationsschicht sowie gebildete AlSi-Eutektikumsschichten entfernt, so dass dann die Emitterbereiche, der BSF-Bereich und die gegebenenfalls vorhandene vorderseitige n⁺-FSF-Struktur freiliegen.

Anschließend wird der Wafer mit einer Passivierungsschicht, z.B. einer Siliziumoxidschicht bedeckt. Die Wafer-Rückseite wird dann lokal auf den Emitterbereichen und den BSF-Bereichen von der Passivierungsschicht befreit. Die gesamte Wafer-Rückseite wird anschließend mit einer leitfähigen, insbesondere einer Aluminiumschicht bedeckt. Diese leitfähige Schicht dient dann der Bildung der interdigitalen Kontaktfingerstruktur.

Im Ergebnis des kurz umrissenen Verfahrens ergibt sich eine neuartige Solarzelle, wobei die n⁺⁺-Basisbereiche auf der Wafer-Rückseite einen lateralen Abstand von den p⁺-Emitterbereichen aufweisen und mindestens die n⁺⁺-Basisbereiche eine Konzentration des Emitterdotiermaterials unterhalb der n-Basiskonzentration des Ausgangswafers besitzen.

Die Erfindung soll nachstehend anhand eines Ausführungsbeispiels unter Zuhilfenahme schematischer Darstellungen der einzelnen Prozessschritte näher erläutert werden.

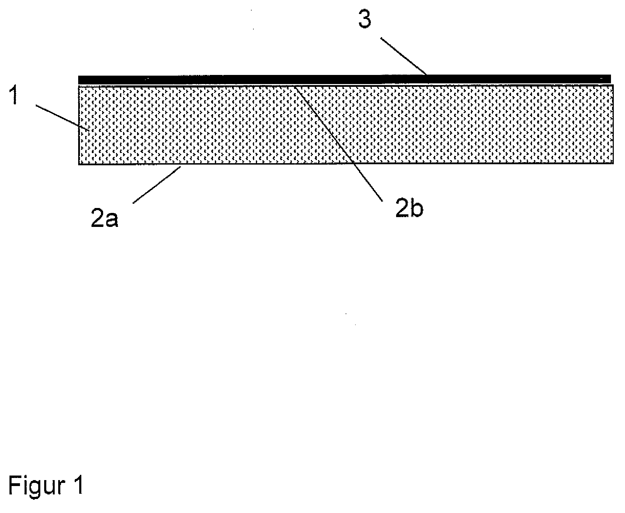

In einem ersten Verfahrensschritt wird gemäß Fig. 1 die gesamte Rückseite 2b des im gezeigten Beispiel untexturierten n-Siliziumwafers 1 mit einer Aluminium- bzw. aluminiumhaltigen Schicht 3 bedeckt, welcher den EmitterDotanden bildet. Die Vorderseite des Wafers ist mit dem Bezugszeichen 2a und die Rückseite mit dem Bezugszeichen 2b gekennzeichent.

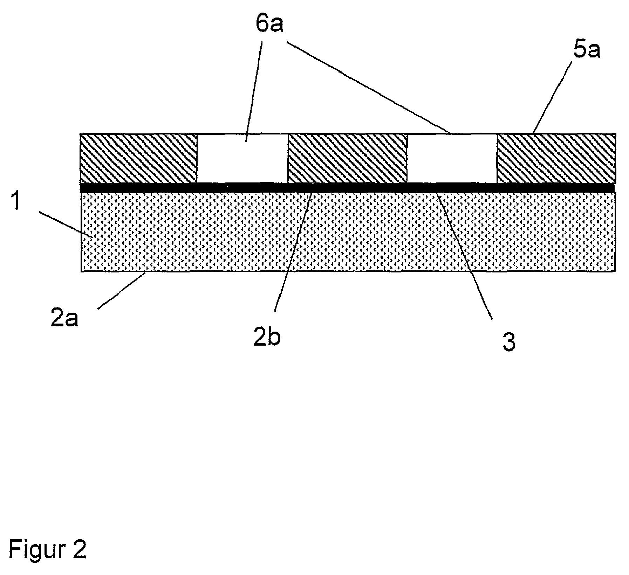

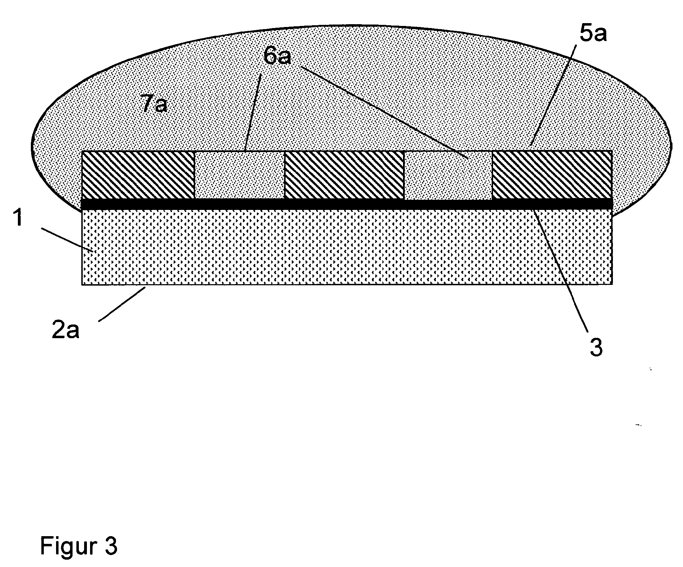

In einem weiteren Schritt wird die aluminiumhaltige Schicht 3 in Kontakt zu einer Schattenmaske 5a gebracht und durch einen Trockenätzschritt in chlorgashaltigem Plasma 7a strukturiert (siehe Fig. 2 und 3).

Alternativ kann auch eine organische Maskenschicht aufgebracht werden, z.B. durch sogenanntes Ink-Jetting, und dann das Aluminium mit nasschemischen Mitteln in den freigebliebenen Bereichen geätzt werden.

Bei beiden erläuterten technologischen Varianten entstehen längliche, streifenförmige Öffnungen 4 im Bereich der Durchbrüche 6a der Maske 5a.

In die streifenförmigen Öffnungen 4 in Aluminiumschicht 3 wird später mit lateralem Abstand zur Aluminiumkante das BSF-Dotiermaterial eindiffundiert.

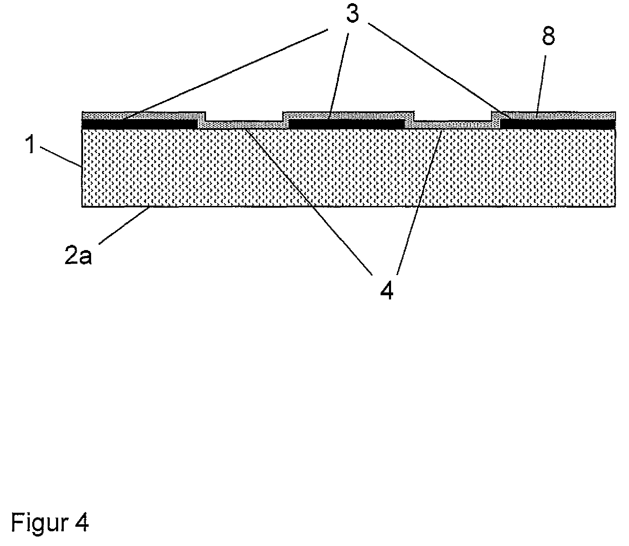

Ein weiterer erfindungsgemäßer Prozessschritt ist nunmehr die Beschichtung der streifenförmig strukturierten aluminiumhaltigen Schicht 3 mit einer Dielektrikumsschicht 8 (siehe Fig. 4). Die Dielektrikumsschicht 8 kann aus einem Oxid, z.B. SiO₂, TiO₂ oder Al₂O₃ bestehen.

Ebenso kann eine Siliziumnitridschicht ausgebildet werden, die ebenfalls gegen Phosphordiffusion dicht ist. Die Abscheidung der Schicht 8 kann durch reaktives Sputtern oder durch ein CVD- oder PECVD-Verfahren erfolgen.

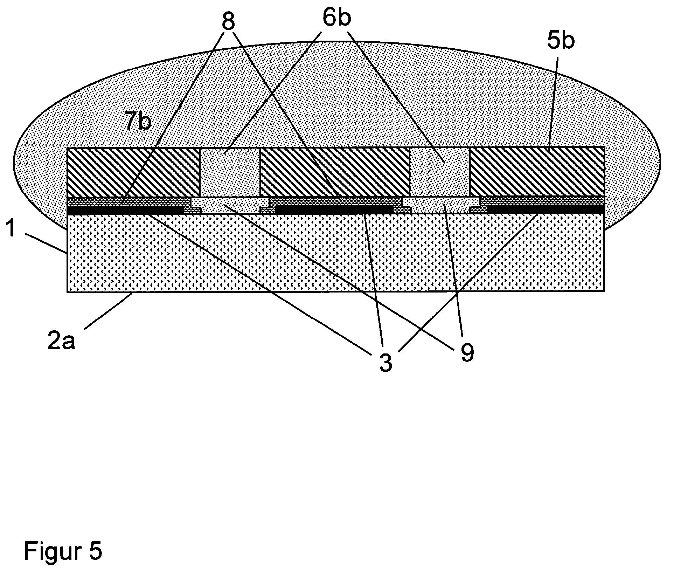

In einem weiteren Verfahrensschritt wird dann die Dielektrikumsschicht 8 durch einen maskierten Ätzschritt im Bereich der Durchbrüche 6b einer weiteren Maske 5b gemäß Fig. 5 entfernt.

Hierbei kann es sich um einen Trockenätzschritt in einem fluorgashaltigen Plasma 7b durch eine Metallfolienmaske hindurch oder um einen Trockenätzschritt in einer fluorgashaltigen Plasmaatmosphäre durch eine organische Maskenschicht hindurch oder um einen nasschemischen Ätzprozess durch eine organische Maskenschicht handeln.

Die streifenförmigen Durchbrüche 6b in der Maske 5b und die damit entstehenden streifenförmigen in der Dielektrikumsschicht 8 freigelegten Bereiche 9 sind erfindungsgemäß schmaler als die streifenförmigen Durchbrüche 6a in der Maske 5a und damit in der aluminiumhaltigen Schicht 3.

Auf diese Weise wird verhindert, dass bei der Phosphordotierung im nächsten Prozessschritt ein Kurzschluss zwischen den Emitter- und BSF-Bereichen auftreten kann.

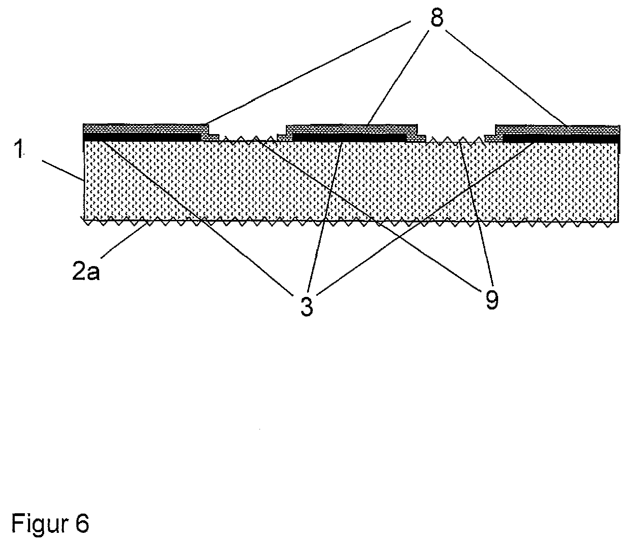

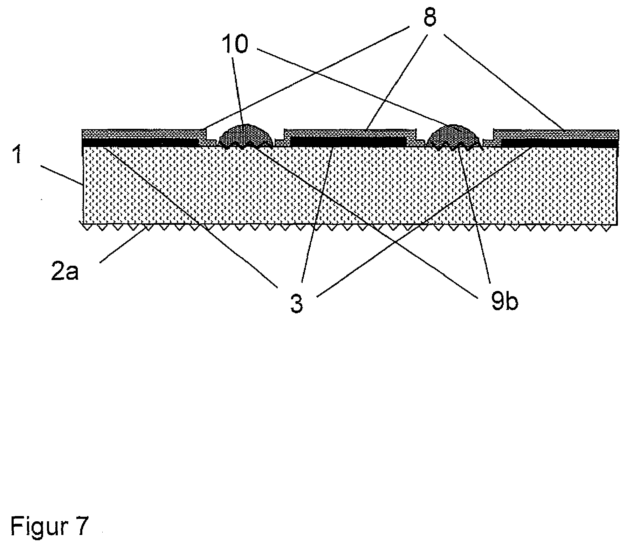

Gemäß der Darstellung nach Fig. 6 wird nunmehr eine standardmäßige Texturierung in einem Tauchbad z.B. aus KOH und Isopropylalkohol (IPA) vorgenommen. Da die aluminiumhaltige Schicht 3 durch die dielektrische Schicht 8 geschützt ist, erfolgt die Texturierung nur an der Wafer-Vorderseite 2a in der gewünschten Weise und in den freigelegten streifenförmigen Bereichen 9b auf der Wafer-Rückseite.

Im Anschluss erfolgt ein Belegen der Durchbrüche 9 in der Abdeckschicht 8 in den Öffnungen der Emitterschicht 4 mit einem stark phosphorhaltigen Material, vorzugsweise einer Paste, die beispielsweise mittels Siebdrucktechnik, Schablonendruck oder Ink-Jetting in lokalen Depots 10 auf der Oberfläche des Wafers 1 abgelagert werden kann. Diese Paste wird bei Temperaturen z.B von 150°C bis 200°C wenn notwendig einem Trocknungsschritt unterzogen.

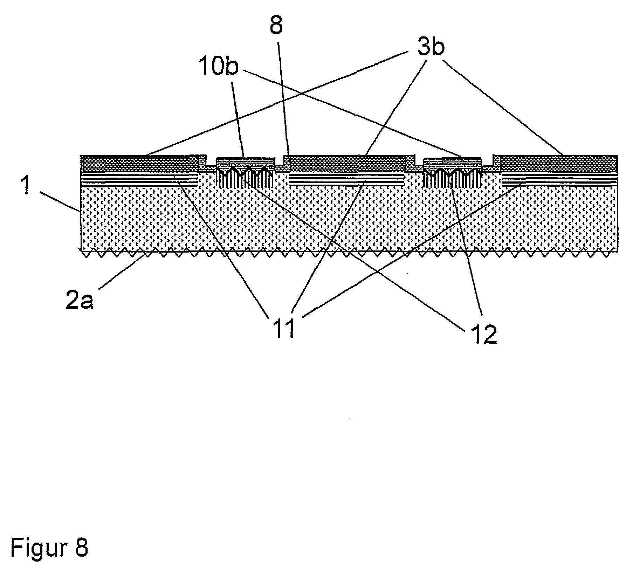

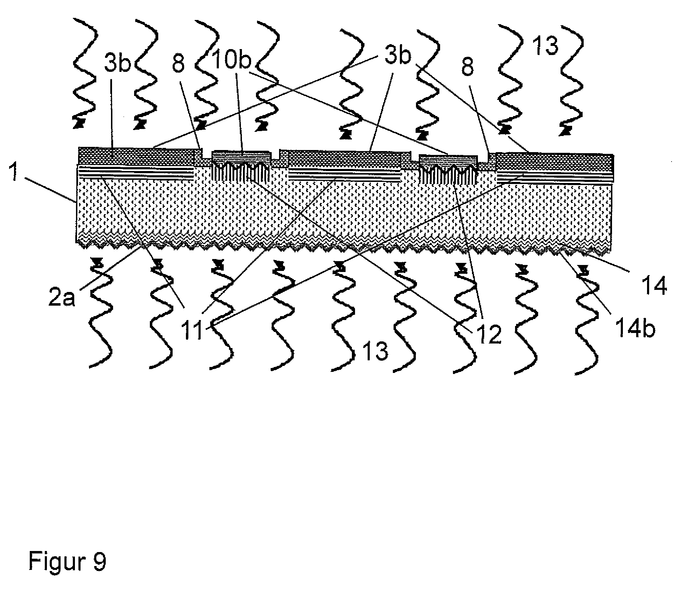

Gemäß den Darstellungen nach den Fig. 8 und 9 erfolgt eine ein- oder wahlweise zweistufige Wärmebehandlung mit der Möglichkeit einer Kodiffusion des Emitterdotanden Aluminium und des BSF-Dotiermaterials Phosphor aus der getrockneten, phosphorhaltigen Schicht 10b.

Ein erster Temperaturbehandlungsschritt erfolgt bei Temperaturen im Bereich zwischen 900°C und 1100°C in einem Stickstoff-Sauerstoff-Gemisch, der die gewünschte Kodiffusion bewirkt (Fig. 8). Ein zweiter Behandlungsschritt findet bei Temperaturen zwischen 800°C und 1000°C in optionaler Weise statt, und zwar in einem phosphorhaltigen Gas 13, vorzugsweise POCl₃.

Der erste Hochtemperaturschritt bewirkt eine Interdiffusion von Silizium und Aluminium und führt zu einer oberflächennahen Mischkristallschicht 3b mit einem eutektischen AlSi-Gefüge und der p⁺-Dotierschicht mit Al-Profil 11.

Simultan diffundiert das Phosphor aus dem Precursordepot 10b in die BSF-Bereiche 9b in die Siliziumoberfläche und führt zu einer tiefen n⁺⁺-Dotierung 12.
Aufgrund der für die Aluminiumdiffusion erforderlichen hohen Temperaturen von >1000°C ist das Diffusionsprofil des Phosphors tiefer ausgebildet als bei sonst üblichen P-Diffusionsprozessen um 900°C.

Der optionale zweite Temperaturbehandlungsschritt bei den besagten üblichen tieferen Temperaturen, diesmal aber mit POCl₃-Atmosphäre nach Fig. 9, bewirkt, dass zusätzlich zur tiefen P-Diffusion in den BSF-Bereichen der Rückseite 9b eine flache P-Diffusion auf der Vorderseite 2a erfolgt, die eine FSF-Schicht (Front Surface Field) 14 mit einem durch Temperatur und Zeit einstellbaren, d.h. vorzugsweise hohen Schichtwiderstand bildet.

Selbstverständlich kann der erste Temperaturbehandlungsschritt auch vor dem Schritt der Beschichtung mit phosphorhaltiger Paste und unabhängig vom anschließenden zweiten Temperaturbehandlungsschritt durchgeführt werden. Ein Vorteil ergibt sich hier dadurch, dass die Prozessparameter des zweiten Diffusionsschritts bei niedrigerer Temperatur unabhängig von dem Prozessparameter des ersten Diffusionsschritts bei höherer Temperatur optimiert werden können.

Ebenso kann die zusätzliche flache Diffusion in der phosphorhaltigen Gasatmosphäre, vorzugsweise mit POCl₃, auch in Fortfall kommen, wenn keine Front Surface Field-Schicht 14 als Vorderseitenpassivierung gewünscht ist. Andererseits könnte diese Passivierung auch in einem zusätzlichen, dritten Diffusionsprozess erfolgen, insbesondere dann, wenn der erste Phosphor-Diffusionsschritt auch mit POCl₃ erfolgt ist.

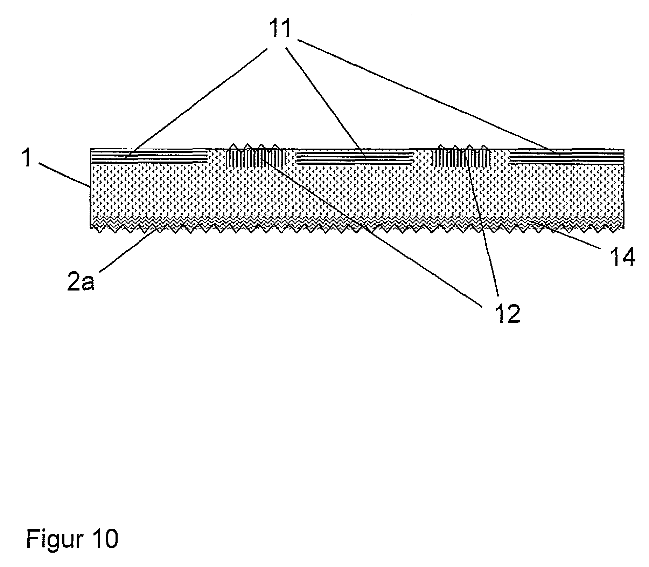

Im folgenden weiteren Prozessverlauf werden in jeweils geeigneten Ätzbädern die Reste der Dotierpaste 10b, das gebildete Phosphor-Silikatglas PSG 14b, die dielektrische Maskierschicht 8 und die AlSi-Eutektikumsschicht 3b abgeätzt, so dass die Emitterbereiche 11, der BSF-Bereich 12 und die vorderseitige n⁺-Schicht 14 freiliegen, und zwar gemäß Fig. 10.

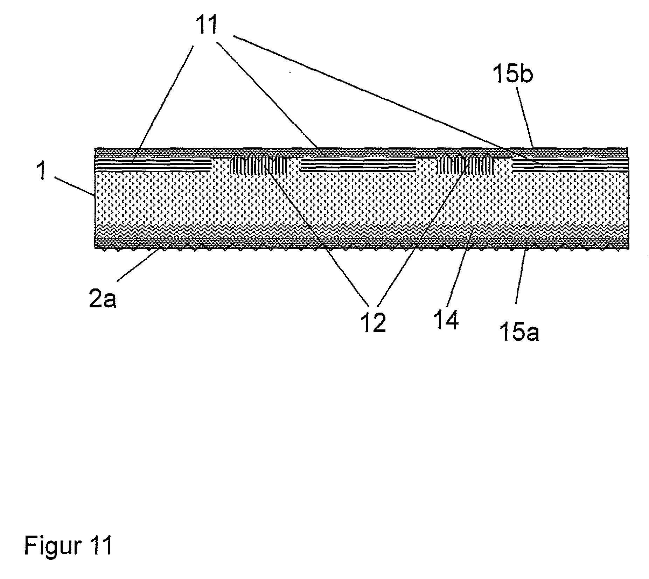

Wie mit der Fig. 11 illustriert, erfolgt in einem weiteren Verfahrensschritt eine beidseitige Beschichtung mit einem Dielektrikum, z.B. durch eine thermische Oxidation beider Seiten des Wafers in einer Wasserdampfatmosphäre, so dass sich eine Siliziumoxidschicht auf der Vorderseite 15a und auf der Rückseite 15b ergibt.

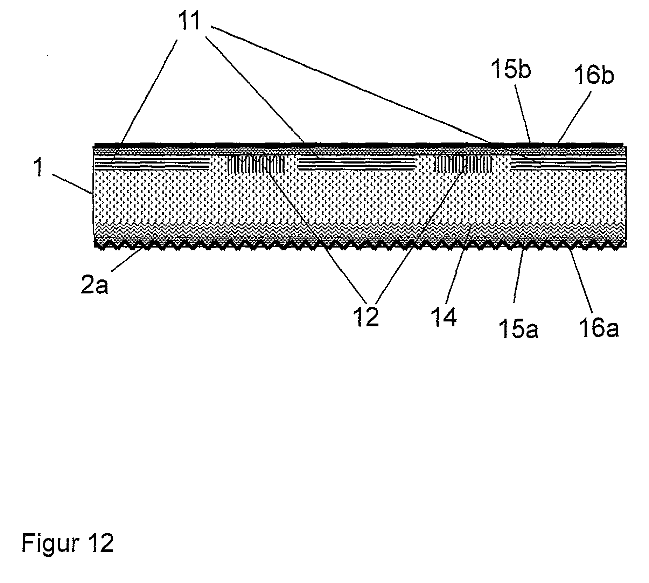

Es besteht optional die Möglichkeit, im Anschluss an die Ausbildung eines thermischen Oxids auf beiden Wafer-Oberflächen beide Seiten mit einer dünnen Aluminiumschicht zu beschichten. Die Schichtdicke liegt hier vorzugsweise in einem Bereich zwischen 10nm und 100nm. Es ergibt sich in Folge eine Aluminiumschicht 16a auf der Vorderseite und eine Aluminiumschicht 16b auf der Rückseite. Die Wafer werden dann derartig beschichtet in einem Bereich zwischen 350°C und 450°C temperaturbehandelt. Der so realisierte Alnealing-Prozess führt zu sehr guten Oberflächenpassivierungsergebnissen (siehe Fig. 12).

Nach Abätzen der Aluminiumschicht liegt der Wafer wieder in einem Zustand vor, wie in Fig. 11 gezeigt.

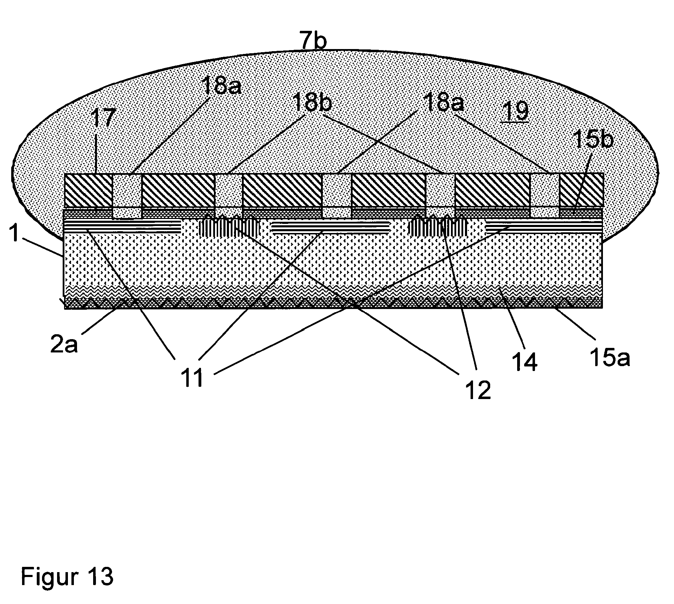

Es erfolgt weiterhin, wie in der Fig. 13 dargestellt, ein lokales Entfernen der Passivierungsschicht 15b auf der Rückseite auf allen Emitter- und BSF-Bereichen, d.h. z.B. gleichzeitig durch maskiertes Trockenätzen in einem fluorgashaltigen Plasma 7b oder ohne Maskierung z.B. mittels Laserablation. Ebenso kann hier nach Abscheiden der Grundmetallisierung das an sich bekannte LFC-Verfahren Anwendung finden.

Die Öffnungen 18a über den Emittergebieten 11 und die Öffnungen 18b über den BSF-Gebieten in der Maske 17 sind kleiner als die Öffnungen 6b in der Maske 5b des vorangegangenen Ätzschritts.
Zum einen erleichtert dies die Justage der Schattenmaske oder der Maskenschicht 17 auf die bereits vorhandene Struktur und zum anderen sollen die Kontaktbereiche der Metallisierung zum Halbleitermaterial möglichst klein sein, um die Oberflächenrekombination zu begrenzen.

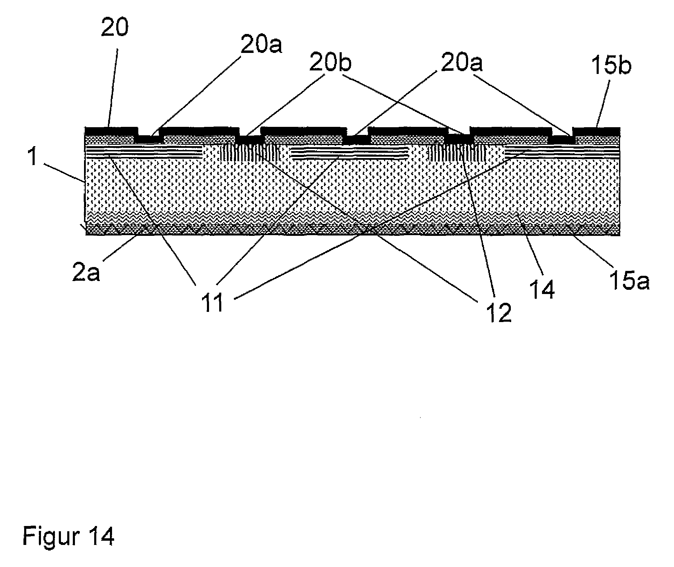

Im folgenden Prozessschritt wird die gesamte Rückseite mit einer Aluminiumschicht 20 bedeckt, so dass somit auch alle im vorangegangenen Ätzschritt freigelegten Kontaktflächen 20a und 20b metallisiert, ansonsten aber von den Halbleitergebieten Emitter 11 und BSF 12 durch die Schicht 15b isoliert sind (siehe Fig. 14).

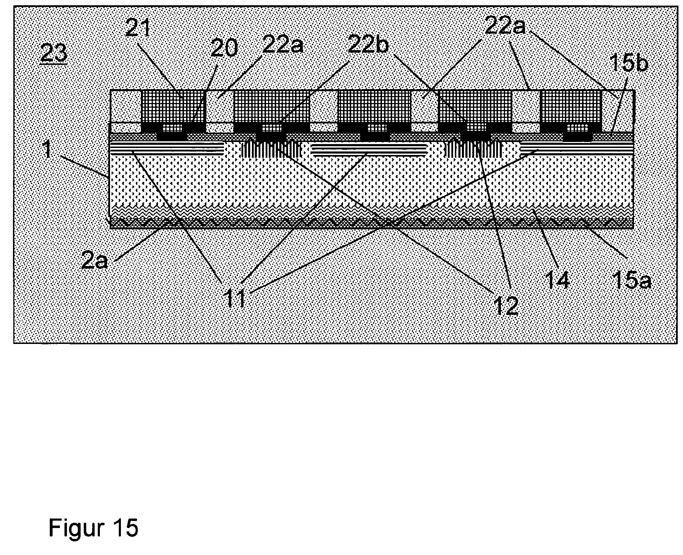

Es erfolgt nun die Aufteilung der Aluminiumschicht 20 in Emitterkontaktbahnen und BSF-Kontaktbahnen dadurch , dass eine säureresistente Schicht 21, vorzugsweise durch strukturiertes Inkjet-Drucken aufgebracht wird. Dieses Auftragen erfolgt derart, dass schmale Zwischenräume 22a zwischen den geplanten Kontaktbereichen 22b freigelassen werden, in denen eine Säure 23, die Aluminium selektiv ätzt, also kein Siliziumoxid angreift, das Aluminium entfernt (siehe Fig. 15). Beim Inkjet-Drucken wird entweder eine organische Paste, die antrocknet, verwendet oder es kommt ein hotmelt-Wachs zum Einsatz, das warm gespritzt wird und auf dem Wafer beim Erkalten erstarrt. Möglich ist auch die Verwendung einer geeigneten Tinte, die einem Trocknungsprozess unterliegt.

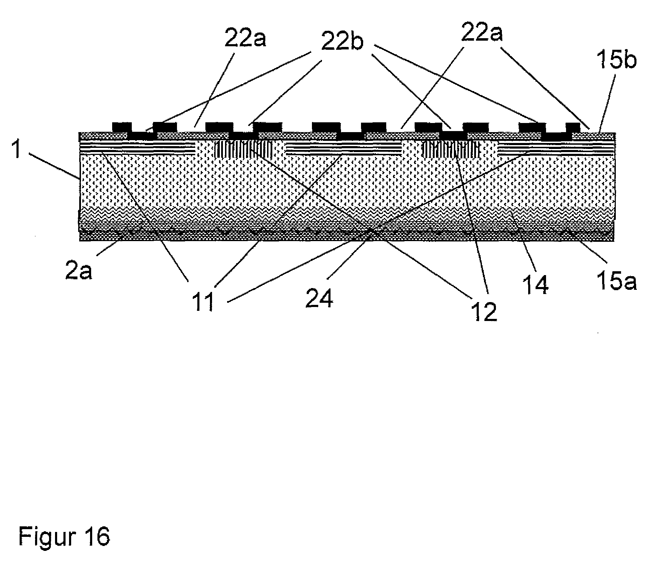

In einem ergänzenden Prozessschritt wird, wie in Fig. 16 angedeutet, eine Antireflexschicht 24 auf der Vorderseite, vorzugsweise aus Siliziumnitrid gebildet. Diese Antireflexschicht ist hinsichtlich Dicke und Brechungsindex auf den optimalen Wirkungsgrad hinsichtlich des Einfangens von Energie aus dem Sonnenlicht ausgebildet. Die Abscheidung dieser Antireflexschicht 24 kann beispielsweise durch plasmagestütztes CVD oder durch reaktives Sputtern erfolgen.

Bevorzugt wird hier das Plasma-CVD-Verfahren angewendet, weil dieses bei Temperaturen oberhalb von 400°C, jedoch unterhalb von 500°C abläuft und somit eine Temperung der Aluminiumkontaktschicht 20 und damit eine Kontaktwiderstandsreduktion bewirkt, ohne eine AlSi-Verflüssigung bei der eutektischen Temperatur von 577°C zu riskieren.

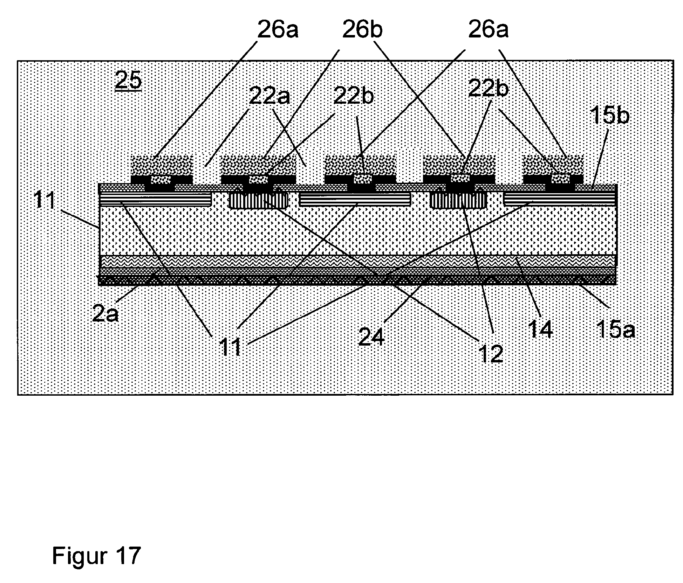

Gemäß Fig. 17 können ergänzend alle Kontakte auf der Rückseite simultan in einem chemischen oder galvanischen Bad 25 oder in einem eventuell lichtunterstützten Abscheideprozess mit einer dicken metallischen Leitschicht versehen werden. Es entstehen hier Emitterleiterbahnverstärkerungen 26a bzw. BSF-Leiterbahnverstärkungen 26b. Die jeweiligen Schichten können entweder aus einem einzigen Material Nickel oder Kupfer oder Silber oder aus mehreren einzelnen Schichten verschiedener Metalle, z.B. Ni+Cu+Sn oder Ni+Ag oder Ni+Au bestehen.

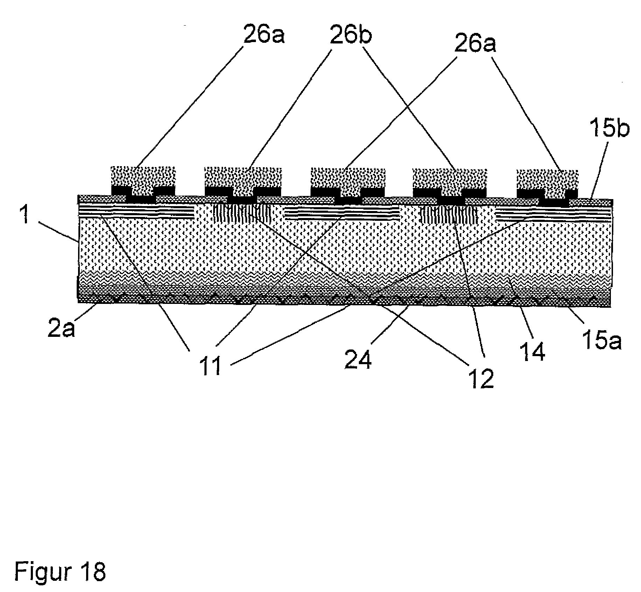

Nach Spülung und Trocknung des Wafers liegt die Rückseiten-Kontaktsolarzelle funktionsfähig, wie in der Fig. 18 gezeigt, vor. Eine Kantenisolation ist nicht notwendig, da die Trennung der Emitterbereiche 11 und der BSF-Bereiche 12 durch den lateralen Abstand und durch die Oxidüberdeckung gewährleistet ist.

## Patentansprüche

1. Verfahren zur Herstellung monokristalliner n-Silizium-Solarzellen mit rückseitigen p⁺-Emitterbereichen (11) und rückseitigen, räumlich getrennten, oberflächennah hochdotierten n⁺⁺-Basisbereichen (12), sowie einer interdigitalen Rückseiten-Kontaktfingerstruktur (22b), welche jeweils in leitender Verbindung mit den p⁺-Emitterbereichen (11) und n⁺⁺-Basisbereichen (12) steht, wobei die n++-Basisbereiche auf einer Rückseite (2b) eines n-Siliziumwafers (1) mit einem lateralen Abstand von den p+-Emitterbereichen gebildet werden,
wobei auf der Rückseite (2b) des n-Siliziumwafers (1) eine Aluminium- oder aluminiumhaltige Dünnschicht (3) abgeschieden wird,
anschließend eine Strukturierung der Dünnschicht (3) mit Erhalt von ersten Öffnungen (4) im Bereich einer späteren Basisdotierung der n++-Basisbereiche (12) vorgenommen wird, wodurch aluminiumfreie streifenförmige Bereiche (4) der Rückseite (2b) des n-Siliziumwafers (1) entstehen,
die strukturierte Aluminium- oder aluminiumhaltige Dünnschicht (3) vollflächig mit einer dielektrischen Schutzschicht (8) bedeckt wird,
die dielektrische Schicht (8) in Bereichen der späteren n++-Basisbereiche (12) geöffnet wird, wobei zweite Öffnungen (9) in Bereichen der späteren Basisdotierung der n++-Basisbereiche (12) über eine Streifenmaske (5b) ausgebildet werden, und wobei eine Breite der erzeugten zweiten Öffnungen (9) kleiner ist als eine Breite der aluminiumfreien streifenförmigen Bereiche (4) der Rückseite (2b) des n-Siliziumwafers (1),
im Bereich der zweiten Öffnungen (9) in der dielektrischen Schutzschicht (8) eine Belegung mit stark phosphorhaltigem Material (10) als BSF-Dotiermaterial (10) zur Ausbildung der oberflächennahen hochdotierten n++- Basisbereiche (12) erfolgt, und
in einem weiteren Prozessschritt ein Eindiffundieren des Aluminiums der Aluminium- oder aluminiumhaltige Dünnschicht (3) in den n-Siliziumwafer (1) zur Ausbildung der strukturierten p+-Emitterbereiche (11) erfolgt.

2. Verfahren nach Anspruch 1,
**dadurch gekennzeichnet, dass**
die Aluminium- oder aluminiumhaltige Dünnschicht (3) durch einen Aufdampf- oder Sputterprozess abgeschieden wird.

3. Verfahren nach Anspruch 1 oder 2
**dadurch gekennzeichnet, dass**
die Strukturierung der abgeschiedenen Aluminium- oder aluminiumhaltige Dünnschicht (3) streifenförmig durch selektives Ätzen erfolgt.

4. Verfahren nach Anspruch 3,
**dadurch gekennzeichnet, dass**
ein Trockenätzen mittels Metall-Schattenmaske (5a) durchgeführt wird.

5. Verfahren nach Anspruch 3,
**dadurch gekennzeichnet, dass**
ein Trockenätzen mittels organischer Maske erfolgt.

6. Verfahren nach Anspruch 3,
**dadurch gekennzeichnet, dass**
der Ätzschritt nasschemisch mittels organischer Ink-Maske ausgeführt wird,

7. Verfahren nach Anspruch 3,
**dadurch gekennzeichnet, dass**
das selektive Ätzen mittels lokalem Drucken einer Ätzpaste erfolgt.

8. Verfahren nach einem der vorangegangenen Ansprüche,
**dadurch gekennzeichnet, dass**
nach Abschluss des Aluminium-Diffusionsschritts Reste der vorhandenen Aluminium- oder aluminiumhaltige Dünnschicht (3) entfernt werden.

9. Verfahren nach Anspruch 1,
**dadurch gekennzeichnet, dass**
der n-Siliziumwafer (1) einer Texturierung unterzogen wird.

10. Verfahren nach Anspruch 9,
**dadurch gekennzeichnet, dass**
die Texturierung auf der n-Siliziumwafer-Vorderseite (2a) und im Bereich der Öffnungen (9) in der dielektrischen Schutzschicht (8) erfolgt.

11. Verfahren nach Anspruch 1,
**dadurch gekennzeichnet, dass**
die Belegung mit dem stark phosphorhaltigem Material (10) durch Aufbringen einer Paste mittels Sieb- oder Schablonendruck oder durch Ink-Jetting in lokalen Depots vorgenommen wird.

12. Verfahren nach Anspruch 11,
**dadurch gekennzeichnet, dass**
die aufgebrachte Paste einem Trocknungsschritt unterzogen wird.

13. Verfahren nach Anspruch 1,
**dadurch gekennzeichnet, dass**
das BSF-Dotiermaterial in einem ein- oder mehrstufigen Temperaturbehandlungsschritt eindiffundiert wird.

14. Verfahren nach Anspruch 13,
**dadurch gekennzeichnet, dass**
das Eindiffundieren des Aluminiums als Emitterdotant der p+-Emitterbereiche (11) und das Eindiffundieren des BSF-Dotiermaterials (10) der n++- Basisbereiche (12) in einem gemeinsamen Temperaturbehandlungsschritt erfolgen.

15. Verfahren nach Anspruch 13 oder 14,
**dadurch gekennzeichnet, dass**
eine weitere Temperaturbehandlung in einer POCI₃-Atmosphäre vorgenommen wird, um auf
der Vorderseite (2a) des n-Siliziumwafers (1) eine flache Phosphor-Diffusionsschicht (14)mit einem durch Behandlungstemperatur und Behandlungszeit einstellbaren Schichtwiderstand zu erzeugen.

16. Verfahren nach Anspruch 15,
**dadurch gekennzeichnet, dass**
über ein Ätzbad Reste (10b) des BSF-Dotiermaterials, während der weiteren Temperaturbehandlung auf der Vorderseite (2a) des n-Siliziumwafers(1) gebildetes Phosphor-Silikatglas (14b), Reste der dielektrischen Schutzschicht (8), sowie gebildete AlSi-Eutektikumsschichtmaterialien (3b) entfernt werden, so dass die p+-Emitterbereiche (11), die n++- Basisbereiche (12)und die gegebenenfalls vorhandene vorderseitige Phosphor-Diffusionsschicht (14)freiliegen.

17. Verfahren nach Anspruch 16,
**dadurch gekennzeichnet, dass**
der n-Siliziumwafer (1) mit mindestens einer Passivierungsschicht (15a, 15b) bedeckt wird.

18. Verfahren nach Anspruch 17,
**dadurch gekennzeichnet, dass**
die Rückseite (2b) des n-Siliziumwafers (1) lokal auf den p+-Emitterbereichen und den n++-Basisbereichen (12)von der Passivierungsschicht (15a, 15b) zur Bildung der Rückseiten-Kontaktfingerstruktur (22b) befreit wird.

19. Verfahren nach Anspruch 18,
**dadurch gekennzeichnet, dass**
die gesamte Rückseite (2b) des n-Siliziumwafers (1) mit einer Aluminiumschicht (16b) bedeckt wird.

20. Verfahren nach Anspruch 19,
**dadurch gekennzeichnet, dass**
die Aluminiumschicht (16b) zur Bildung interdigitaler Kontaktfinger (22b) der Rückseiten-Kontaktfingerstruktur (22b) strukturiert wird.

## Claims

1. Method for producing monocrystalline n-silicon solar cells comprising p⁺ emitter regions (11) on the rear side and spatially separated n⁺⁺ base regions (12) on the rear side that are highly doped near the surface, as well as an interdigital contact finger structure (22b) on the rear side that is conductively connected in each case to the p⁺ emitter regions (11) and n⁺⁺ base regions (12), wherein the n⁺⁺ base regions are formed on a rear side (2b) of an n-silicon wafer (1) with a lateral distance from the p⁺ emitter regions,
wherein
a thin aluminium or aluminium-containing layer (3) is deposited on the rear side (2b) of the n-silicon water (1),
structuring of the thin layer (3) is undertaken so as to obtain first openings (4) in the region of a later base doping of the n⁺⁺ base regions (12), as a result of which aluminium-free strip-like regions (4) of the rear side (2b) of the n-silicon wafer (1) are formed,
the structured thin aluminium or aluminium-containing layer (3) is covered over the entire surface with a dielectric protective layer (8),
the dielectric layer (8) is opened in regions of the later n⁺⁺ base regions (12), wherein second openings (9) are formed in regions of the later base doping of the n⁺⁺ base regions (12) via a strip mask (5b), and wherein a width of the second openings (9) produced is smaller than a width of the aluminium-free strip-like regions (4) of the rear side (2b) of the n-silicon wafer (1),
in the region of the second openings (9) in the dielectric protective layer (8) covering with material (10) of high phosphorus content as BSF doping material (10) is carried out so as to form the highly doped n⁺⁺ base regions (12) near the surface, and
in a further process step diffusing of the aluminium of the thin aluminium or aluminium-containing layer (3) into the n-silicon wafer (1) is carried out so as to form the structured p⁺ emitter regions (11).

2. Method according to claim 1,
**characterised in that**
the thin aluminium or aluminium-containing layer (3) is deposited by a vapour deposition or sputtering process.

3. Method according to claim 1 or 2,
**characterised in that**
the structuring of the thin aluminium or aluminium-containing layer (3) deposited is carried out in the form of strips by selective etching.

4. Method according to claim 3
**characterised in that**
a dry etching by means of a metal shadow mask (5a) is carried out.

5. Method according to claim 3,
**characterised in that**
a dry etching by means of an organic mask is carried out.

6. Method according to claim 3,
**characterised in that**
the etching step is carried out by wet chemistry by means of an organic ink mask.

7. Method according to claim 3,
**characterised in that**
the selective etching is carried out by means of local printing of an etching paste.

8. Method according to one of the preceding claims,
**characterised in that**
after conclusion of the aluminium diffusion step residues of the thin aluminium or aluminium-containing layer (3) present are removed.

9. Method according to claim 1,
**characterised in that**
the n-silicon wafer (1) is subjected to a texturing.

10. Method according to claim 9,
**characterised in that**
the texturing is carried out on the n-silicon water front side (2a) and in the region of the openings (9) in the dielectric protective layer (8).

11. Method according to claim 1,
**characterised in that**
the covering with the material (10) of high phosphorus content is undertaken by applying a paste by means of screen or template printing or by ink-jetting in local depots.

12. Method according to claim 11,
**characterised in that**
the paste applied is subjected to a drying step.

13. Method according to claim 1,
**characterised in that**
diffusing in of the BSF doping material is effected in a single- or multi-stage heat treatment step.

14. Method according to claim 13,
**characterised in that**
the diffusing in of the aluminium as an emitter dopant of the p⁺ emitter regions (11) and the diffusing in of the BSF doping material (10) of the n⁺⁺ base regions (12) are carried out in a common heat treatment step.

15. Method according to claim 13 or 14,
**characterised in that**
a further heat treatment is carried out in a POCl₃ atmosphere in order to produce on the front side (2a) of the n-silicon wafer (1) a flat phosphorus diffusion layer (14) having a layer resistance that can be adjusted by means of the treatment temperature and treatment time.

16. Method according to claim 15,
**characterised in that**
residues (10b) of the BSF doping material, phosphorus silicate glass (14b) formed on the front side (2a) of the n-silicon wafer (1) during the further heat treatment, residues of the dielectric protective layer (8) and AlSi eutectic layer materials (3b) formed are removed via an etching bath, so that the p⁺ emitter regions (11), the n⁺⁺ base regions (12) and the phosphorus diffusion layer (14) that may be present on the front side are exposed.

17. Method according to claim 16,
**characterised in that**
the n-silicon wafer (1) is covered with at least one passivation layer (15a, 15b).

18. Method according to claim 17,
**characterised in that**
the rear side (2b) of the n-silicon wafer (1) is freed locally from the passivation layer (15a, 15b) on the p⁺ emitter regions and the n⁺⁺ base regions (12) so as to form the contact finger structure (22b) on the rear side.

19. Method according to claim 18,
**characterised in that**
the entire rear side (2b) of the n-silicon wafer (1) is covered with an aluminium layer (16b).

20. Method according to claim 19,
**characterised in that**
the aluminium layer (16b) is structured so as to form interdigital contact fingers (22b) of the contact finger structure (22b) on the rear side.

## Revendications

1. Procédé de fabrication de cellules solaires en silicium monocristallin dopé n avec des régions émettrices arrières p⁺ (11) et des régions de base fortement dopées n⁺⁺ (12) proche de la surface arrières et spatialement séparées, ainsi qu'avec une structure de contact inter-digitée des faces arrières (22b), laquelle est respectivement en liaison conductrice avec les régions émettrices p⁺ (11) et les régions de base n⁺⁺ (12), dans lequel les régions de base n⁺⁺ sont formées sur une face arrière (2b) d'une tranche en silicium dopé n (1) à une distance latérale par rapport aux régions émettrices p⁺, dans lequel
sur la face arrière (2b) de la tranche en silicium dopé n (1), une couche mince (3) en aluminium ou contenant de l'aluminium est déposée,
ensuite, une structuration de la couche mince (3) avec obtention de premiers orifices (4) dans la région d'un dopage de base ultérieur des régions de base n⁺⁺ (12) est réalisée de manière à créer des régions en forme de bandes (4) exemptes d'aluminium de la face arrière (2b) de la tranche en silicium dopé n (1),
la couche mince (3) en aluminium ou contenant de l'aluminium structurée est recouverte sur toute sa surface avec une couche de protection diélectrique (8),
la couche diélectrique (8) est ouverte dans des régions des régions de base n⁺⁺ (12) ultérieures, des seconds orifices (9) étant formés dans des régions des régions de base dopées n⁺⁺ (12) ultérieures par l'intermédiaire d'un masque en bandes (5b), et une épaisseur des seconds orifices (9) créés étant inférieure à une épaisseur des régions en formes de bandes (4) exemptes d'aluminium de la face arrière (2b) de la tranche en silicium dopé n (1),
un revêtement avec un matériau hautement chargé de phosphore (10) en tant que matériau de dopage BSF (10) dans la région des seconds orifices (9) dans la couche de protection diélectrique (8) est réalisé pour la formation de régions de base fortement dopées n⁺⁺ (12) et proches de la surface, et,
dans une autre étape de procédé, une diffusion vers l'intérieur de la couche mince (3) en aluminium ou contenant de l'aluminium dans la tranche en silicium dopé n (1) est réalisée pour la formation des régions émettrices p⁺ (11) structurées.

2. Procédé selon la revendication 1,
**caractérisé en ce que**
la couche mince (3) en aluminium ou contenant de l'aluminium est déposée par un procédé de dépôt en phase vapeur ou par pulvérisation.

3. Procédé selon les revendications 1 ou 2,
**caractérisé en ce que**
la structuration en forme de bandes de la couche mince (3) en aluminium ou contenant de l'aluminium déposée est réalisée par une gravure sélective.

4. Procédé selon la revendication 3,
**caractérisé en ce que**
une gravure à sec est effectuée au moyen d'un masque perforé métallique (5a).

5. Procédé selon la revendication 3,
**caractérisé en ce que**
une gravure à sec est effectuée au moyen d'un masque organique.

6. Procédé selon la revendication 3,
**caractérisé en ce que**
l'étape de gravure est exécutée par un procédé chimique humide au moyen d'un masque organique d'encre.

7. Procédé selon la revendication 3,
**caractérisé en ce que**
que la gravure sélective est effectuée au moyen d'une impression locale de pâte de gravure.

8. Procédé selon l'une des revendications précédentes,
**caractérisé en ce que**
après l'étape de diffusion de l'aluminium, les résidus présents de la couche mince (3) en aluminium ou contenant de l'aluminium sont enlevés.

9. Procédé selon la revendication 1,
**caractérisé en ce que**
la tranche en silicium dopé n (1) est soumise à une texturation.

10. Procédé selon la revendication 9,
**caractérisé en ce que**
la texturation est effectuée sur la face avant de la tranche en silicium dopé n (2a) et au niveau des orifices (9) dans la couche de protection diélectrique (8).

11. Procédé selon la revendication 1,
**caractérisé en ce que**
le revêtement avec le matériau hautement chargé en phosphore (10) est réalisé par application d'une pâte au moyen d'une sérigraphie ou d'une impression au pochoir ou par une impression par jet d'encre en dépôt local

12. Procédé selon la revendication 11,
**caractérisé en ce que**
la pâte appliquée est soumise à une étape de séchage.

13. Procédé selon la revendication 1,
**caractérisé en ce que**
que matériau de dopage BSF est diffusé vers l'intérieur en une étape de traitement en température avec un ou plusieurs paliers.

14. Procédé selon la revendication 13,
**caractérisé en ce que**
que la diffusion vers l'intérieur de l'aluminium en tant que dopant d'émetteur des régions émettrices p⁺ (11) et la diffusion vers l'intérieur du matériau de dopage BSF (10) des régions de base n⁺⁺ (12) sont réalisées dans une étape de traitement en température commune.

15. Procédé selon les revendications 13 ou 14,
**caractérisé en ce que**
un nouveau traitement en température est réalisé dans une atmosphère de POCl₃ afin de créer une couche de diffusion de phosphore (14) plane sur la face avant (2a) de la tranche en silicium dopé n (1) avec une résistance de couche réglable par une température de traitement et une durée de traitement.

16. Procédé selon la revendication 15,
**caractérisé en ce que**,
pendant le nouveau traitement en température sur la face avant (2a) de la tranche en silicium dopé n (1), des résidus (10b) du matériau de dopage BSF, du silicate de phosphore formé (14b), des résidus de la couche de protection diélectrique (8) ainsi que des produits de couche eutectique AlSi (3b) formés sont enlevés par un bain de gravure, de sorte que les régions émettrices p⁺ (11), les régions de base n⁺⁺ (12) et la couche de diffusion de phosphore (14) éventuellement présente sur la face avant sont librement exposées.

17. Procédé selon la revendication 16,
**caractérisé en ce que**
la tranche en silicium dopé n (1) est recouverte avec au moins une couche de passivation (15a, 15b).

18. Procédé selon la revendication 17,
**caractérisé en ce que**
la face arrière (2b) de la tranche en silicium dopé n (1) est libérée localement de la couche de passivation (15a, 15b) sur les régions émettrices p⁺ et les régions de base n⁺⁺ (12) pour la formation de la structure de contact inter-digitée (22b) des faces arrières.

19. Procédé selon la revendication 18,
**caractérisé en ce que**
la face arrière (2b) complète de la tranche en silicium dopé n (1) est recouverte d'une couche d'aluminium (16b).

20. Procédé selon la revendication 19,
**caractérisé en ce que**
la couche d'aluminium (16b) est structurée pour la formation du contact inter-digité (22b) de la structure de contact inter-digitée (22b) des faces arrière.
